# EUROPEAN PATENT APPLICATION

(11) **EP 3 118 643 A1**
(43) Date of publication of application: **18.01.2017**
(21) Application number: 15176569.0
(22) Date of filing: 14.07.2015
(51) Int. Cl.: G01R 33/48, G01R 33/561, G01R 33/565

(54) **DYNAMIC PROPELLER MR IMAGING**

(71) Applicant: Koninklijke Philips N.V., 5656 AE Eindhoven (NL)
(72) Inventor: VISSER, Frederik, 5656 AE Eindhoven (NL); VAN DEN BRINK, Johan Samuel, 5656 AE Eindhoven (NL)
(74) Representative: Cohen, Julius Simon

(57) **Abstract**

The invention relates to a method of view-sharing PROPELLER MR imaging of a body (10) of a patient. It is an object of the invention to provide a method that enables dynamic contrast-enhanced MR imaging to monitor the passage of a contrast agent through an imaged body portion with sufficient spatial resolution. The method of the invention comprises the steps of:
a) generating MR signals by subjecting at least a portion of the body (10) to a MR imaging sequence comprising a number of RF pulses and switched magnetic field gradients;
b) acquiring the MR signals as a plurality of k-space segments (21-29) in temporal succession, each k-space segment comprising a number of substantially parallel k-space lines, wherein the k-space segments (21-29) are rotated about the center of k-space, so that the total acquired data set of MR signals spans a circle in k-space, wherein a common central circular region (30) of k-space is covered by all k-space segments (21-29); and
c) reconstructing a time series of MR images, wherein each MR image reconstructed at least from
- k-space data from the central circular region (30) of k-space comprised in a first set of k-space segments, in combination with
- k-space data from peripheral regions of k-space comprised in a second set of k-space segments,
wherein the first set comprises a smaller number of k-space segments than the second set. Moreover, the invention relates to a MR device (1) and to a computer program for a MR device (1).

## Description

### FIELD OF THE INVENTION

The invention relates to the field of magnetic resonance (MR) imaging. It concerns a method of MR imaging of a body of a patient placed in the examination volume of a MR device. The invention also relates to a MR device and to a computer program to be run on a MR device.

### BACKGROUND OF THE INVENTION

Image-forming MR methods which utilize the interaction between magnetic fields and nuclear spins in order to form two-dimensional or three-dimensional images are widely used nowadays, notably in the field of medical diagnostics, because for the imaging of soft tissue they are superior to other imaging methods in many respects, do not require ionizing radiation and are usually not invasive.

According to the MR method in general, the body of the patient to be examined is arranged in a strong, uniform magnetic field Bo whose direction at the same time defines an axis (normally the z-axis) of the co-ordinate system to which the measurement is related. The magnetic field Bo produces different energy levels for the individual nuclear spins in dependence on the magnetic field strength which can be excited (spin resonance) by application of an electromagnetic alternating field (RF field) of defined frequency (so-called Larmor frequency, or MR frequency). From a macroscopic point of view the distribution of the individual nuclear spins produces an overall magnetization which can be deflected out of the state of equilibrium by application of an electromagnetic pulse of appropriate frequency (RF pulse) while the corresponding magnetic field B₁ of this RF pulse extends perpendicular to the z-axis, so that the magnetization performs a precessional motion about the z-axis. The precessional motion describes a surface of a cone whose angle of aperture is referred to as flip angle. The magnitude of the flip angle is dependent on the strength and the duration of the applied electromagnetic pulse. In the case of a so-called 90° pulse, the magnetization is deflected from the z axis to the transverse plane (flip angle 90°).

After termination of the RF pulse, the magnetization relaxes back to the original state of equilibrium, in which the magnetization in the z direction is built up again with a first time constant T₁ (spin lattice or longitudinal relaxation time), and the magnetization in the direction perpendicular to the z direction relaxes with a second and shorter time constant T₂ (spin-spin or transverse relaxation time). The transverse magnetization and its variation can be detected by means of receiving RF coils which are arranged and oriented within an examination volume of the MR device in such a manner that the variation of the magnetization is measured in the direction perpendicular to the z-axis. The decay of the transverse magnetization is accompanied by dephasing taking place after RF excitation caused by local magnetic field inhomogeneities facilitating a transition from an ordered state with the same signal phase to a state in which all phase angles are uniformly distributed. The dephasing can be compensated by means of a refocusing RF pulse (for example a 180° pulse). This produces an echo signal (spin echo) in the receiving coils.

In order to realize spatial resolution in the body, time-varying magnetic field gradients extending along the three main axes are superposed on the uniform magnetic field Bo, leading to a linear spatial dependency of the spin resonance frequency. The signal picked up in the receiving coils then contains components of different frequencies which can be associated with different locations in the body. The signal data obtained via the receiving coils correspond to the spatial frequency domain and are called k-space data. The k-space data usually include multiple lines acquired of different phase encoding. Each line is digitized by collecting a number of samples. A set of k-space data is converted to an MR image by means of Fourier transformation.

Dynamic MR imaging is a challenging topic that opens up a wide field in medical diagnosis, such as, for example, contrast-enhanced MR angiography, perfusion imaging, interventional imaging and functional brain imaging. Dynamic (time-resolved) imaging sequences are ideally acquired with temporal and spatial resolution that are matched to the phenomenon of interest. Due to the nature of MR signal acquisition, however, improving temporal resolution while maintaining spatial resolution is a conflict of goals. A commonly used approach for improving the temporal resolution of dynamic MR imaging is the so-called keyhole technique in which k-space is covered completely only on the first MR image and only the central k-space data is updated on each subsequent MR image.

In contrast-enhanced MR imaging, many diagnostic decisions are based on a pre- and post-contrast TSE (Turbo Spin Echo) scan. The dynamics of the passage of the contrast agent through the tissue within the imaged body portion can often not be analyzed, especially in brain imaging, because the achievable resolution is not sufficient to delineate the structures of interest. The application of the above-mentioned keyhole technique does not solve this problem for multiple reasons, e.g. the low SNR (signal-to-noise-ratio) and the incompatibility of keyhole imaging with the requirement of a smooth MR signal course in TSE imaging under T₂ decay over the echo train.

### SUMMARY OF THE INVENTION

From the foregoing it is readily appreciated that there is a need for an improved MR imaging technique. It is consequently an object of the invention to provide a method that enables dynamic contrast-enhanced MR imaging to monitor the passage of a contrast agent through an imaged body portion with sufficient spatial resolution.

In accordance with the invention, a method of MR imaging of a body of a patient placed in the examination volume of a MR device is disclosed. The method comprises the steps of:
a) generating MR signals by subjecting at least a portion of the body to a MR imaging sequence comprising a number of RF pulses and switched magnetic field gradients;
b) acquiring the MR signals as a plurality of k-space segments in temporal succession, each k-space segment comprising a number of substantially parallel k-space lines, wherein the k-space segments are rotated about the center of k-space, so that the total acquired data set of MR signals spans a circle in k-space, wherein a common central circular region of k-space is covered by all k-space segments; and
c) reconstructing a time series of MR images, wherein each MR image reconstructed at least from
   - k-space data from the central circular region of k-space comprised in a first set of k-space segments, in combination with
   - k-space data from peripheral regions of k-space comprised in a second set of k-space segments,
      wherein the first set comprises a smaller number of k-space segments than the second set.

The so-called PROPELLER imaging technique has been developed to overcome problems with respect to motion in MR imaging. In the PROPELLER concept (Periodically Rotated Overlapping ParalEL Lines, see James G. Pipe: "Motion Correction With PROPELLER MRI: Application to Head Motion and Free-Breathing Cardiac Imaging", Magnetic Resonance in Medicine, vol. 42, 1999, pages 963-969), MR signal data are acquired in k-space in *N* strips, each consisting of *L* parallel k-space lines, corresponding to the *L* lowest frequency phase-encoding lines in a Cartesian-based k-space sampling scheme. Each strip, which is also referred to as k-space blade, is rotated in k-space by an angle of, for example, 180°/*N*, so that the total MR data set spans a circle in k-space. If a full k-space data matrix having a diameter *M* is desired, then *L* and *N* may be chosen so that *L*×*N*=*M*×_{π}/2. One essential characteristic of PROPELLER is that a central circular region in k-space, having a diameter *L*, is acquired for each k-space blade. This central region can be used to reconstruct a low-resolution MR image for each k-space blade. The low-resolution MR images are compared to each other to remove in-plane displacements and phase errors, which are due to patient motion. These factors are corrected for in each k-space blade in accordance with the PROPELLER scheme. A suitable technique such as cross-correlation is employed to determine which k-space blades were acquired with significant displacement or include other types of artefacts. As the MR signal data are combined in k-space before the reconstruction of the final MR image, the MR data from k-space blades are weighted according to the artefact level detected by cross-correlating the k-space blades, so that artefacts are reduced in the final MR image. The PROPELLER technique makes use of oversampling in the central portion of k-space in order to obtain an MR image acquisition technique that is robust with respect to motion of the examined patient during MR signal acquisition. Moreover, due to the weighted averaging of k-space blades PROPELLER 'averages out' further imaging artefacts resulting from, for example, Bo inhomogeneities or inaccurate coil sensitivity maps when parallel imaging techniques like SENSE are used for MR data acquisition.

The method for dynamic MR imaging according to the invention exploits the inherent substantial oversampling by PROPELLER scanning (or similar scanning schemes) of the center of k-space which contains the crucial temporal information regarding contrast evolution. The gist of the invention is the reconstruction of each MR image of the time series from the k-space data from the central circular region of k-space acquired in only a few temporally close k-space segments (blades), complemented by the k-space data from peripheral regions of k-space acquired in a larger number of k-space segments and, thus, during a longer period of time. Preferably, the k-space segments of the first set are acquired in temporal succession during a period that is temporally more closely related to a time point attributed to the respective MR image than the acquisition period of the k-space segments of the second set. The essence of the method of the invention is, in other words, based on updating the center of k-space more often than the periphery of k-space. The total number of acquired k-space blades does not change with respect to a conventional PROPELLER imaging scan with the same resolution. However, benefit is taken from the dynamic information being available at a higher frame rate from the k-space center than from the k-space periphery.

Each MR image of the time series reconstructed according to the invention will represent the contrast characteristics of the time point at which the k-space data of the first set is sampled. This time point is attributed to the respective MR image. In this way, a minimal time resolution can be achieved. A single k-space segment can be acquired within 2-3 seconds, while the total scan time is typically on the order of 3 to 5 minutes. Hence, the method of the invention enables, for example, a time-resolved study of the passage of a contrast agent by PROPELLER imaging without compromising the image resolution.

In a preferred embodiment of the invention, the k-space data from which the respective MR image is reconstructed may be complemented by k-space data from at least one circular or annular region of k-space comprised in a further set of k-space segments, wherein the further set comprises a number of k-space segments which is intermediate between the numbers of k-space segments of the first and second sets. This extents the concept of the invention to dynamic imaging using view sharing with a number of concentric (circular/annular) regions around k-space center (comparable to the known TRICKS, TWIST or CAPRI segmentation approaches), wherein the different regions are updated at different rates. The central k-space region is updated more frequently than the (one or more) intermediate k-space regions. The intermediate k-space regions, in turn, are updated more frequently than the peripheral k-space regions.

Typically, the k-space segments of the first set cover k-space incompletely, while the k-space segments of the second set span a full circle in k-space. For updating the k-space data in the central region of k-space it is not necessary that the k-space segments of the first set fully cover k-space. For the image reconstruction according to the invention at the desired resolution it is sufficient that full k-space coverage is obtained by the combination of the k-space data of the first and second sets complementing each other.

In one possible embodiment of the invention, the first set comprises only k-space segments acquired prior to or at the time point attributed to the respectively reconstructed MR image, wherein one k-space segment is updated in the first set between the reconstructions of successive MR images of the time series. For example, a k-space segment that is temporally closest to the time point of the respective MR image replaces the k-space segment in the first set with the largest temporal distance from the time point of the MR image. This corresponds to the known sliding window technique, in which only the most recently acquired k-space data is updated before the next MR image is reconstructed. It is advantageous to average a number of two or more (typically three to eight) k-space segments in the first set for improving SNR. However, by updating only one k-space segment in the first set between successive reconstructions a high temporal resolution corresponding to the acquisition time of a single k-space segment is maintained.

In a preferred embodiment of the invention, the second set may comprise all acquired k-space segments of the respective imaging scan. This results in an optimum SNR, while the resolution of contrast enhanced features is not confined to the inverse of the radius of the central k-space region, as the reconstruction is based on augmenting the data with outer k-space from the second set, which then effectively determines the (nominal) resolution of the image.

Alternatively, the second set may comprise only k-space segments acquired after the inflow of a contrast agent into the imaged portion of the body. In this embodiment, the time series of MR images is reconstructed in a post-processing step, i.e. after the whole scan is completed. If the dynamic process is considered as a wash-in process (with little MR signal decay), this approach is advantageous, as it will reduce potential blurring of the contrast enhanced features.

According to another alternative, the second set may comprise a number of k-space segments acquired prior to or at the time point attributed to the respectively reconstructed MR image, wherein one k-space segment is updated in the second set between the reconstructions of successive MR images of the time series. This again corresponds to the known sliding window approach which may also be applied for updating the peripheral k-space data. However, the number of k-space segments included in the second set must be considerably larger than the number of k-space segments of the first set as full coverage in the k-space periphery is required for the second set. This embodiment will improve the temporal contrast representation in outer k-space. It may be advantageous to adapt the temporal segment sampling order from a linear angular increment to consecutively sampling (nearly) orthogonal segments. Another advantageous sampling order increases the angle of subsequent k-space segments by the golden angle, or a close pre-defined angle for a homogeneous distribution of angular density of segments.

In order to be able to fully analyze the inflow of a contrast agent into the imaged portion of the body, a set of k-space segments spanning a full circle in k-space should be acquired prior to the inflow of the contrast agent. This makes sure, that MR images can be reconstructed that are not influenced by the contrast agent for the time points before the inflow of the contrast agent.

In a preferred embodiment of the invention, the imaging sequence is a multi-echo imaging sequence comprising a number of 'shots', wherein each k-space segment corresponds to a train of MR echo signals generated in one or more shots of the multi-echo imaging sequence. The sequence may be, for example, a 'turbo' spin echo (TSE) sequence, wherein each k-space segment corresponds to a train of MR echo signals generated in a single shot (i.e. after a single RF excitation) of the multi-echo imaging sequence.

As in conventional PROPELLER imaging, the method of the invention may also comprise the step of estimating and correcting motion-induced displacements and phase errors in the k-space subsets. For example, low-resolution MR images reconstructed from the central k-space data of the k-space subsets are compared to each other to remove in-plane displacements and phase errors, which are caused by patient motion. These factors should be corrected for in each k-space subset in accordance with the invention prior to reconstructing the single-subset MR images. This renders the method of the invention robust with respect to motion of the examined patient during MR signal acquisition.

The method of the invention described thus far can be carried out by means of a MR device including at least one main magnet coil for generating a uniform, steady magnetic field Bo within an examination volume, a number of gradient coils for generating switched magnetic field gradients in different spatial directions within the examination volume, at least one body RF coil for generating RF pulses within the examination volume and/or for receiving MR signals from a body of a patient positioned in the examination volume, a control unit for controlling the temporal succession of RF pulses and switched magnetic field gradients, and a reconstruction unit for reconstructing MR images from the received MR signals. The method of the invention can be implemented by a corresponding programming of the reconstruction unit and/or the control unit of the MR device.

The method of the invention can be advantageously carried out on most MR devices in clinical use at present. To this end it is merely necessary to utilize a computer program by which the MR device is controlled such that it performs the above-explained method steps of the invention. The computer program may be present either on a data carrier or be present in a data network so as to be downloaded for installation in the control unit of the MR device.

### BRIEF DESCRIPTION OF THE DRAWINGS

The enclosed drawings disclose preferred embodiments of the present invention. It should be understood, however, that the drawings are designed for the purpose of illustration only and not as a definition of the limits of the invention. In the drawings:
Figure 1 shows a MR device for carrying out the method of the invention;
Figure 2 schematically illustrates the PROPELLER acquisition scheme of the invention.

### DETAILED DESCRIPTION OF THE EMBODIMENTS

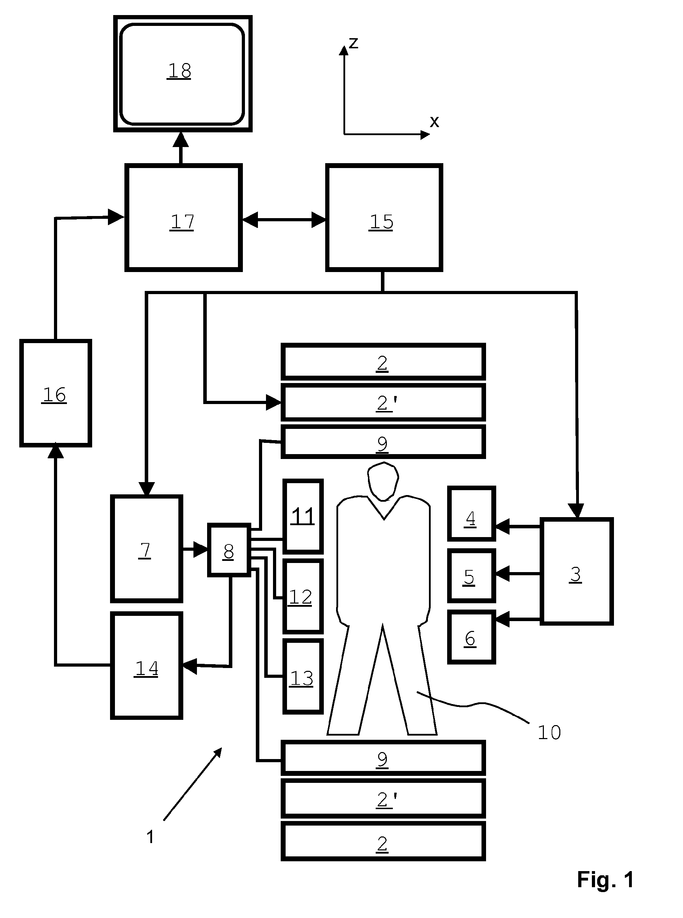

With reference to Figure 1, a MR device 1 is shown as a block diagram. The device comprises superconducting or resistive main magnet coils 2 such that a substantially uniform, temporally constant main magnetic field Bo is created along a z-axis through an examination volume. The device further comprises a set of (1^{st}, 2^{nd}, and - where applicable - 3^{rd} order) shimming coils 2', wherein the current flow through the individual shimming coils of the set 2' is controllable for the purpose of minimizing Bo deviations within the examination volume.

A magnetic resonance generation and manipulation system applies a series of RF pulses and switched magnetic field gradients to invert or excite nuclear magnetic spins, induce magnetic resonance, refocus magnetic resonance, manipulate magnetic resonance, spatially and otherwise encode the magnetic resonance, saturate spins, and the like to perform MR imaging.

More specifically, a gradient amplifier 3 applies current pulses or waveforms to selected ones of whole-body gradient coils 4, 5 and 6 along x, y and z-axes of the examination volume. A digital RF frequency transmitter 7 transmits RF pulses or pulse packets, via a send/receive switch 8, to a body RF coil 9 to transmit RF pulses into the examination volume. A typical MR imaging sequence is composed of a packet of RF pulse segments of short duration which, together with any applied magnetic field gradients, achieve a selected manipulation of nuclear magnetic resonance signals. The RF pulses are used to saturate, excite resonance, invert magnetization, refocus resonance, or manipulate resonance and select a portion of a body 10 positioned in the examination volume. The MR signals are also picked up by the body RF coil 9.

For generation of MR images of limited regions of the body 10 or for scan acceleration by means of parallel imaging, a set of local array RF coils 11, 12, 13 are placed contiguous to the region selected for imaging. The array coils 11, 12, 13 can be used to receive MR signals induced by body-coil RF transmissions.

The resultant MR signals are picked up by the body RF coil 9 and/or by the array RF coils 11, 12, 13 and demodulated by a receiver 14 preferably including a preamplifier (not shown). The receiver 14 is connected to the RF coils 9, 11, 12 and 13 via send/receive switch 8.

A host computer 15 controls the shimming coils 2' as well as the gradient pulse amplifier 3 and the transmitter 7 to generate any of a plurality of MR imaging sequences, such as echo planar imaging (EPI), echo volume imaging, gradient and spin echo imaging, fast spin echo imaging, and the like. For the selected sequence, the receiver 14 receives a single or a plurality of MR data lines in rapid succession following each RF excitation pulse. A data acquisition system 16 performs analog-to-digital conversion of the received signals and converts each MR data line to a digital format suitable for further processing. In modern MR devices the data acquisition system 16 is a separate computer which is specialized in acquisition of raw image data.

Ultimately, the digital raw image data are reconstructed into an image representation by a reconstruction processor 17 which applies a Fourier transform or other appropriate reconstruction algorithms, such as SENSE or GRAPPA. The MR image may represent a planar slice through the patient, an array of parallel planar slices, a three-dimensional volume, or the like. The image is then stored in an image memory where it may be accessed for converting slices, projections, or other portions of the image representation into appropriate format for visualization, for example via a video monitor 18 which provides a man-readable display of the resultant MR image.

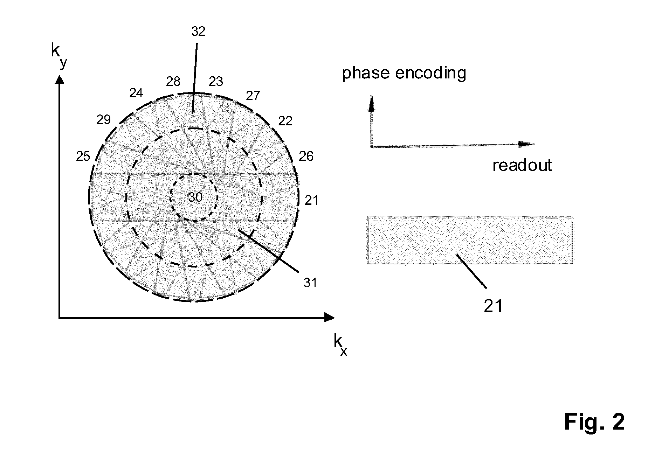

Figure 2 illustrates the k-space sampling of PROPELLER MR imaging according to the invention. As shown in the left illustration of Figure 2, nine k-space segments (blades) 21-29 are acquired. Each blade 21-29 covers a different portion of k-space, wherein a central circular region 30 of k-space is acquired for each blade 21-29. The blades 21-29 are rotated about the center of k-space, so that the total acquired MR data set spans a circle in k-space. In the right illustration of Figure 2 a single k-space blade 21 is shown which is acquired using a single shot of a TSE sequence. The orientation of the phase encoding direction and the readout direction relative to the blade orientation is maintained for all rotation angles of the k-space blades 21-29. Motion-induced displacements and phase errors in the blades 21-29 are detected and corrected like in conventional PROPELLER imaging.

According to the invention, a time series of MR images is reconstructed from the k-space blades 21-29. Each MR image of the time series is reconstructed from k-space data from the central circular region 30 of k-space comprised in a first set of k-space blades. The k-space data used for reconstructing the respective MR image is complemented by k-space data from a peripheral region 32 of k-space comprised in a second set of k-space blades. This k-space data is further complemented by k-space data from an annular region 31 of k-space comprised in a further set of k-space blades. For example, a sliding window approach is used, in which the first MR image of the time series is reconstructed using the central k-space data of successively acquired three k-space blades 21, 22, 23 forming the first set for the second MR image, while the second MR image is reconstructed using the central k-space data of successively acquired k-space blades 22, 23, 24 forming the first set for the second MR image. The third MR image is reconstructed using the central k-space data of successively acquired k-space blades 23, 24, 25 forming the first set for the third MR image, and so forth. The second set from which the k-space data in region 32 is used comprises all acquired k-space blades 21-29 in all MR images of the time series. The further set of k-space blades, from which the k-space data in the annular region 31 is used for the respective MR image reconstruction, comprises, for example, k-space blades 21, 22, 23, 24, 25, for a first number of MR images of the time series, and k-space blades 25, 26, 27, 28, 29 for the following MR images.

Each MR image of the time series thus reconstructed represents the contrast characteristics of the time point at which the k-space data of the respective first set is sampled. Of course, the k-space blades of each first set are not acquired at a single time point in a strict mathematical sense, but within a certain time interval which is short as compared to the time interval required for covering the full circle in k-space by the acquisition of the k-space blades of the second set. The correspondingly determined time point is attributed to the respective MR image.

In other words, the first set always comprises k-space blades acquired prior to or at the time point attributed to the respectively reconstructed MR image, wherein one k-space blade that is temporally closest to the time point is updated in the first set between the reconstructions of successive MR images of the time series. The temporal resolution of the time series of MR images is given by the repetition time TR of the TSE sequence as this is the time required for acquiring a single k-space blade in this specific embodiment.

A time series of seven MR images can thus be reconstructed in the depicted embodiment. This enables, for example, a time-resolved study of the passage of a contrast agent by PROPELLER imaging with a high image resolution.

## Claims

**1.** Method of MR imaging of a body (10) of a patient placed in the examination volume of a MR device (1), the method comprising the steps of:
a) generating MR signals by subjecting at least a portion of the body (10) to a MR imaging sequence comprising a number of RF pulses and switched magnetic field gradients;
b) acquiring the MR signals as a plurality of k-space segments (21-29) in temporal succession, each k-space segment comprising a number of substantially parallel k-space lines, wherein the k-space segments (21-29) are rotated about the center of k-space, so that the total acquired data set of MR signals spans a circle in k-space, wherein a common central circular region (30) of k-space is covered by all k-space segments (21-29); and
c) reconstructing a time series of MR images, wherein each MR image reconstructed at least from
- k-space data from the central circular region (30) of k-space comprised in a first set of k-space segments, in combination with
- k-space data from peripheral regions of k-space comprised in a second set of k-space segments,
wherein the first set comprises a smaller number of k-space segments than the second set.

**2.** Method of claim 1, wherein the MR signals are acquired according to a PROPELLER scheme, such that the k-space segments are k-space blades (21-29) that are rotated about the center of k-space.

**3.** Method of claim 1 or 2, wherein the k-space data from which each MR image is reconstructed is complemented by k-space data from at least one circular or annular region (31) of k-space comprised in a further set of k-space segments, wherein the further set comprises a number of k-space segments which is intermediate between the numbers of k-space segments of the first and second sets.

**4.** Method of any one of claims 1-3, wherein the k-space segments of the first set are acquired in temporal succession during a period that is temporally more closely related to a time point attributed to the respective MR image than the acquisition period of the k-space segments of the second set.

**5.** Method of any one of claims 1-4, wherein the k-space segments of the first set cover k-space incompletely, while the k-space segments of the second set span a full circle in k-space.

**6.** Method of any one of claims 1-5, wherein the first set comprises only k-space segments acquired prior to or at the time point attributed to the respectively reconstructed MR image, wherein one k-space segment is updated in the first set between the reconstructions of successive MR images of the time series.

**7.** Method of any one of claims 1-6, wherein the second set comprises all acquired k-space segment.

**8.** Method of any one of claims 1-6, wherein the second set comprises only k-space segments acquired after the inflow of a contrast agent into the imaged portion of the body (10).

**9.** Method of any one of claims 1-6, wherein the second set comprises a number of k-space segments acquired prior to or at the time point attributed to the respectively reconstructed MR image, wherein one k-space segment is updated in the second set between the reconstructions of successive MR images of the time series.

**10.** Method of claim 9, wherein a set of k-space segments spanning a full circle in k-space is acquired prior to the inflow of a contrast agent into the imaged portion of the body (10).

**11.** Method of any one of claims 1-10, wherein the imaging sequence is a multi-echo imaging sequence comprising a number of shots, wherein each k-space segment corresponds to a train of MR echo signals generated in one or more shots of the multi-echo imaging sequence.

**12.** Method of any one of claims 1-11, further comprising the step of estimating and correcting motion-induced displacements and phase errors in the k-space segments prior to reconstructing the MR images.

**13.** MR device for carrying out the method claimed in claims 1-12, which MR device (1) includes at least one main magnet coil (2) for generating a uniform, steady magnetic field Bo within an examination volume, a number of gradient coils (4, 5, 6) for generating switched magnetic field gradients in different spatial directions within the examination volume, at least one RF coil (9) for generating RF pulses within the examination volume and/or for receiving MR signals from a body (10) of a patient positioned in the examination volume, a control unit (15) for controlling the temporal succession of RF pulses and switched magnetic field gradients, and a reconstruction unit (17) for reconstructing MR images from the received MR signals, wherein the MR device (1) is arranged to perform the following steps:
a) generating MR signals by subjecting at least a portion of the body (10) to a MR imaging sequence comprising a number of RF pulses and switched magnetic field gradients;
b) acquiring the MR signals as a plurality of k-space segments (21-29) in temporal succession, each k-space segment comprising a number of substantially parallel k-space lines, wherein the k-space segments (21-29) are rotated about the center of k-space, so that the total acquired data set of MR signals spans a circle in k-space, wherein a common central circular region (30) of k-space is covered by all k-space segments (21-29); and
c) reconstructing a time series of MR images, wherein each MR image reconstructed at least from
- k-space data from the central circular region (30) of k-space comprised in a first set of k-space segments, in combination with
- k-space data from peripheral regions of k-space comprised in a second set of k-space segments,
wherein the first set comprises a smaller number of k-space segments than the second set.

**12.** Computer program to be run on a MR device, which computer program comprises instructions for:
a) generating a MR imaging sequence comprising a number of RF pulses and switched magnetic field gradients;
b) acquiring the MR signals as a plurality of k-space segments (21-29) in temporal succession, each k-space segment comprising a number of substantially parallel k-space lines, wherein the k-space segments (21-29) are rotated about the center of k-space, so that the total acquired data set of MR signals spans a circle in k-space, wherein a common central circular region (30) of k-space is covered by all k-space segments; and
c) reconstructing a time series of MR images, wherein each MR image reconstructed at least from
- k-space data from the central circular region (30) of k-space comprised in a first set of k-space segments, in combination with
- k-space data from peripheral regions of k-space comprised in a second set of k-space segments,
wherein the first set comprises a smaller number of k-space segments than the second set.
